# EUROPEAN PATENT SPECIFICATION

(11) **EP 3 324 195 B1**
(45) Date of publication and mention of the grant of the patent: **20.04.2022**
(21) Application number: 17191433.6
(22) Date of filing: 15.09.2017
(51) Int. Cl.: G01R 15/20, H01L 43/02

(54) **ELECTRONIC COMPONENT**
ELEKTRONISCHE KOMPONENTE
COMPOSANT ÉLECTRONIQUE

(30) Priority: 04.11.2016 JP 2016216374
(43) Date of publication of application: 23.05.2018
(73) Proprietor: AISIN SEIKI KABUSHIKI KAISHA, Kariya-shi, Aichi-ken, 448-8650 (JP)
(72) Inventor: MITSUBAYASHI, Noriaki, KARIYA-SHI, AICHI-KEN 448-8650 (JP); FUJITA, Noriaki, KARIYA-SHI, AICHI-KEN 448-8650 (JP)
(74) Representative: Cabinet Beau de Loménie

(56) References cited:
- JP-A- 2013 024 851
- JP-B2- 5 659 389
- US-A1- 2014 176 124

## Description

### TECHNICAL FIELD

This disclosure relates to an electronic component mounted on a substrate.

### BACKGROUND DISCUSSION

In the related art, a lead-attached electronic component (hereinafter, referred to as a "lead component") in which a lead is provided and extends from a molded portion, has been used as one of electronic components to be mounted on a substrate (e.g., a plastic substrate or the like). To mount this type of lead component on the substrate, the lead is formed in a desired shape, mounted on the substrate, and then welded by a soldering process (e.g., JP 2013-024851A (Reference 1), JP 2016-031304A (Reference 2), and JP 2014-139556A (Reference 3)). See also JP 5 659 389 (Reference 4).

A current sensor disclosed in Reference 1 includes an annular magnetic core having a gap disposed to surround a conductor through which a current to be measured flows, a magnetoelectric conversion element having a lead terminal disposed in the gap, and a substrate on which a driving circuit for the magnetoelectric conversion element and the like are mounted. The magnetoelectric conversion element has element support portions formed by bending the lead terminals at about the right angle, a bent portion for positioning is formed by further bending a tip portion of at least one of the element support portions toward the substrate at about the right angle, and the magnetoelectric conversion element is mounted on the substrate by inserting the bent portion into a mounting lead terminal insertion hole.

A current detecting device disclosed in Reference 2 includes a substrate disposed in the vicinity of a conductor that generates a magnetic flux at a circumference in response to a flow of current, and a magnetism detecting element having a plurality of leads arranged at a predetermined pitch. The magnetism detecting element has leads in which the tip side thereof is bent to be insertable into a lead hole in the substrate, and the leads are mounted on the substrate.

A current sensor disclosed in Reference 3 includes a housing that holds a bus bar to which a current is applied, a core disposed around the bus bar, a circuit board fixed in the housing in a state where the circuit board is disposed to face the housing, and a detecting element configured to detect the current. The detecting element has an element main body held in the housing, and a plurality of connection terminals fixed into through-holes in the circuit board, and the connection terminals are mounted by being inserted through one of both surfaces of the circuit board, which faces the housing.

According to the technologies disclosed in References 1 to 3, there are many bent portions of the lead, which need to be formed by a plurality of processes when forming the lead. For this reason, manufacturing costs are increased.

Thus, a need exists for an electronic component capable of inhibiting an increase in manufacturing costs.

### SUMMARY

A feature of an electronic component according to an aspect of this disclosure resides in that the electronic component includes a first package having an element sealed therein; a lead electrically connected to the element in the first package and including a bent portion that is bent outside the first package; a second package provided at an end opposite to an end to which the first package is connected among both ends of the lead; and a substrate including a first hole through which the first package and a first package side portion on the first package side closer to the first package than the bent portion in the lead are inserted, and a second hole into which at least a part of the second package is inserted.

With this configuration, the lead can be bent at one position and in the same direction. Therefore, since it is possible to easily perform the lead formation, which is required for mounting the electronic component on the substrate, the manufacturing costs can be reduced.

It is preferable that, when the bent portion is regarded as a first bent portion, the lead has a second bent portion bent between the first bent portion and the second package, and the second package and a second package side portion on the second package side closer to the second package than the second bent portion in the lead are inserted through the second hole.

With this configuration, both of the first and second packages may be disposed such that the first and second packages do not protrude from the side of the substrate where the first and second packages are inserted. Therefore, since it is possible to reduce a mounting height of the side of the substrate where the first and second packages are inserted, a degree of freedom in arranging the electronic component may be increased.

It is preferable that the second package is fixed by being press-fitted into the second hole.

With this configuration, it is possible to precisely position the second package with respect to the substrate. Therefore, it is possible to improve the precision in positioning the electronic component.

It is preferable that the first package side portion of the lead is in contact with an inner circumferential surface of the first hole.

With this configuration, it is possible to precisely position the first package with respect to the substrate. Therefore, it is possible to improve the precision in positioning the electronic component.

It is preferable that the first hole has a groove portion formed in the inner circumferential surface of the first hole in an insertion direction of the lead, and the first package side portion is inserted through the groove portion.

With this configuration, it is possible to precisely position the lead with respect to the substrate. Therefore, it is possible to improve the precision in positioning the electronic component.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a perspective view of an electronic component according to a first embodiment;
Fig. 2 is a side sectional view of the electronic component according to the first embodiment;
Fig. 3 is a partially enlarged view of the electronic component according to the first embodiment;
Fig. 4 is a top plan view of the electronic component according to the first embodiment;
Fig. 5 is a view of a lead of the electronic component according to the first embodiment as viewed in an extension direction thereof;
Fig. 6 is a perspective view of an electronic component according to a second embodiment; and
Fig. 7 is a side sectional view of the electronic component according to the second embodiment.

### DETAILED DESCRIPTION

### 1. First Embodiment

An electronic component disclosed here is configured to be able to be inexpensively mounted on a substrate in a state of being provided uprightly with respect to the substrate. Hereinafter, an electronic component 1 of the present embodiment will be described. Further, hereinafter, as an example of the electronic component 1, a Hall integrated circuit (IC) will be described.

The Hall IC is configured to detect a current to be measured that flows through a conductor 2. Here, when the current flows through the conductor 2, a magnetic field is generated around the conductor 2 as an axial center thereof in response to the magnitude of the current, and a magnetic flux is generated by the magnetic field. A magnetic flux density of the magnetic flux is detected by a Hall element embedded in the Hall IC, and the Hall IC detects the current (current value) flowing through the conductor 2 based on the magnetic flux density detected by the Hall element.

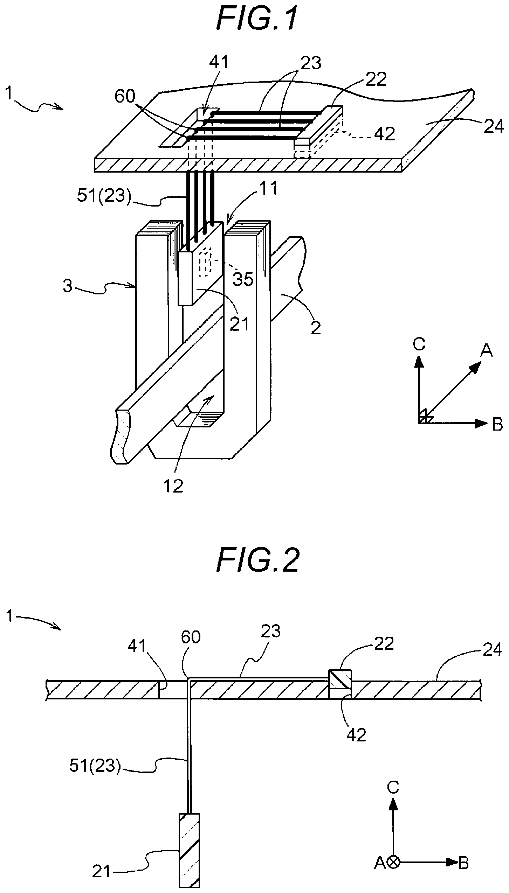

Fig. 1 illustrates a perspective view of the electronic component 1. For ease of understanding, a direction in which the conductor 2 through which the current to be measured flows extends is referred to as a direction A, and directions orthogonal to the direction A are referred to as a direction B and a direction C.

Here, the conductor 2 is provided to penetrate a groove portion 12 of an annular core 3. In the present embodiment, the conductor 2 corresponds to a three-phase rotary electric machine, and a bus bar electrically connected to an inverter that controls a rotation of the three-phase rotary electric machine. In the case of the three-phase rotary electric machine, three bus bars are provided. In this case, the electronic components 1 are provided in the three conductors 2, respectively. However, Fig. 1 illustrates only one bus bar.

The core 3 is configured by a magnetic body which has an opening 11 at an annular part, and the groove portion 12. The conductor 2 is inserted through the groove portion 12 of the core 3. Therefore, the magnetic flux formed around the conductor 2 is easily collected by the core 3.

The electronic component 1 includes a first package 21, a second package 22, and leads 23. An element 35 is sealed in the first package 21. In the present embodiment, the element 35 corresponds to a Hall element which detects the magnetic flux density of the magnetic flux formed around the conductor 2 in response to the current that flows through the conductor 2. The Hall element detects the magnetic flux density of the magnetic flux formed at the opening 11 of the groove portion 12. The first package 21 is molded by using resin in a state where the Hall element is embedded in the first package 21. The first package 21 is disposed such that a detection surface of the Hall element is orthogonal to the magnetic flux formed at the opening 11 of the groove portion 12.

The lead 23 is electrically connected to the element 35 in the first package 21 and has a bent portion 60 bent outside the first package 21. As described above, the element 35 (Hall element in the present embodiment) is sealed in the first package 21. The lead 23 is formed as a conductor and electrically connected to terminals of the element 35. In the present embodiment, the Hall element has three terminals including a power source terminal, a reference voltage terminal, and an output terminal. In an example of Fig. 1, three of four leads 23 are electrically connected to the three terminals, and the remaining one lead 23 is connected to a non-connected terminal (so-called NC terminal) which is not electrically connected to the three terminals. The four leads 23 are molded by using resin together with the element 35.

The lead 23 extends from the first package 21 (in the direction C in an example of Fig. 1), and the lead 23 is bent (in the direction B in the example of Fig. 1) so as to have a predetermined angle, outside the first package 21, with respect to the direction in which the lead 23 extends from the first package 21. In the present embodiment, the four leads 23 are provided, and all of the four leads 23 are bent in the same direction.

The second package 22 is provided at an end opposite to an end to which the first package 21 is connected among both ends of the lead 23. As described above, in the present embodiment, the first package 21 is disposed in the opening 11 of the core 3. The second package 22 is molded separately from the first package 21 by using resin, and provided to be spaced apart from the first package 21 outward from the groove portion 12 of the core 3. Therefore, the second package 22 is supported by the leads 23 extending from the first package 21 to the second package 22, and the bent portions 60 are provided by bending the leads 23 between the first package 21 and the second package 22.

The first package 21 and the second package 22 are mounted on a substrate 24. The substrate 24 has a first hole 41 and a second hole 42. The first package 21 and a first package side portion 51 closer to the first package 21 than the bent portion 60 in the lead 23 are inserted through the first hole 41. The first package side portion 51 refers to a portion between the first package 21 and the bent portion 60 of the lead 23 that connects the first package 21 and the second package 22. Since the first package 21, together with the first package side portion 51, is inserted through the first hole 41, the first hole 41 is formed by penetrating the substrate 24 in a thickness direction (corresponding to the direction C in the example of Fig. 1) so as to have a size that enables at least the first package 21 to pass through the first hole 41.

At least a part of the second package 22 is inserted into the second hole 42. In the present embodiment, a part of the lead 23, which extends from the first package 21 and is bent at the bent portion 60, is embedded in the second package 22. The second package 22 is disposed to be embedded in the second hole 42 from a surface directed toward the substrate 24 (bottom surface) when the second package 22 is mounted on the substrate 24, among the surfaces of the second package 22, to a position where the lead 23 is provided (see Fig. 2).

In this case, the second hole 42 may have a size equal to a size of the second package 22 such that the second package 22 is fixed by being press-fitted into the second hole 42. Therefore, the electronic component 1 may be accurately positioned with respect to the substrate 24.

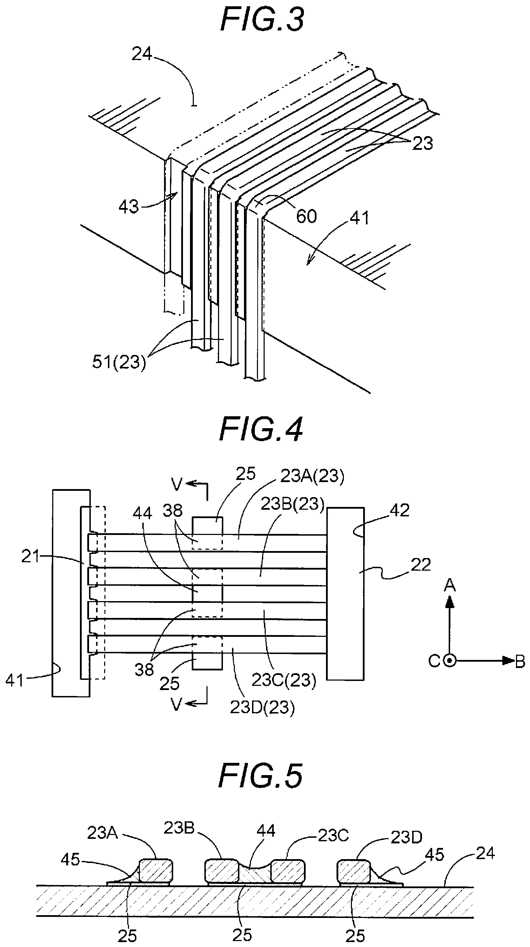

Here, Fig. 2 illustrates a side sectional view of the electronic component 1. As illustrated in Fig. 2, in the present embodiment, the lead 23 is provided such that the first package side portion 51 is in contact with an inner circumferential surface of the first hole 41. Further, as illustrated in Fig. 3, the first hole 41 has groove portions 43 formed in the inner circumferential surface of the first hole 41 in a direction in which the leads 23 are inserted, and a soldering process may be performed in a state where the first package side portions 51 are inserted through the groove portions 43. This configuration may further improve precision in positioning the electronic component 1 with respect to the substrate 24.

Fig. 4 illustrates a top plan view of the leads 23. Each of the lead 23 has an electrode portion 38 which is soldered to a land 25 formed on the substrate 24. The land 25 refers to an exposed portion of a conductor provided such that the electronic component 1 is electrically connected to the substrate 24. The electrode portion 38 of the lead 23, which is electrically connected to the element 35 of the electronic component 1, is electrically connected to the land 25.

As illustrated in Fig. 4, the plurality of leads 23 is provided in parallel with one another. In the present embodiment, the four leads 23 are provided. One of the four leads 23 is a unused lead which is not used. The "unused lead which is not used" corresponds to the non-connected terminal (so-called NC terminal) which is not electrically connected.

The leads 23 on both outer sides of the plurality of (four) leads 23 in the parallel direction of the leads 23 are disposed such that only outer portions of the lands 25 in the parallel direction in a top plan view protrude from the outer leads 23. The "parallel direction of the lead 23" means a direction of a row in which the plurality of (four) leads 23, which is parallel to one another, is arranged in parallel, that is, a direction orthogonal to a direction in which the plurality of (four) leads 23 extends. In the example of Fig. 4, the parallel direction of the lead 23 corresponds to the direction A. Therefore, "the outer leads 23 on both outer sides in the parallel direction" correspond to a lead 23A and a lead 23D among the leads 23. As illustrated in Fig. 4, in a top plan view of the substrate 24, the lands 25 of the substrate 24, which are used to solder the lead 23A and the lead 23D, are provided to protrude only outward in the parallel direction from the lead 23A and the lead 23D, respectively, but the lands 25 of the substrate 24 are provided so as not to protrude inward in the parallel direction from the lead 23A and the lead 23D.

Therefore, in a case where the lead 23A and the lead 23D are soldered to the lands 25, respectively, as illustrated in Fig. 5 which is a cross-sectional view taken along line V-V in Fig. 4, fillets 45 are formed only at outer sides of the lead 23A and the lead 23D in the parallel direction, respectively. Further, Fig. 5 illustrates solder between the land 25 and the bottom surface of the lead 23, but the solder may be interposed between the land 25 and the bottom surface of the lead 23.

Here, among the plurality of (four) leads 23, one lead is an unused lead, and the unused lead is configured as a lead at a central portion other than the leads on both outer sides. The leads 23 on both outer sides are the lead 23A and the lead 23D in the present embodiment. For this reason, the unused lead corresponds to a lead 23B or a lead 23C. Hereinafter, a configuration in which the lead 23C is the unused lead will be described.

The electrode portion 38 of the unused lead (lead 23C) is connected, by soldering, to the lead 23B which is adjacent to the unused lead and disposed at the central portion. Here, as illustrated in Fig. 4, the land 25, which is used to connect the lead 23B, is provided so as not to protrude toward the lead 23A in a top plan view, and the land 25, which is used to connect the lead 23C, is provided so as not to protrude toward the lead 23D. That is, the lands 25 are provided so as not to protrude between the lead 23A and the lead 23B and between the lead 23C and the lead 23D. Meanwhile, the lead 23C and the lead 23B are electrically connected to each other by solder through a solder bridge 44. In this case, the land 25 may be formed between the lead 23C and the lead 23B to easily form the solder bridge 44 between the lead 23C and the lead 23B (see Fig. 5).

Here, as described above, the lead 23 has the bent portion 60, but the bent portion 60 may be configured as the electrode portion 38. In this case, the bent portion 60 is provided to be in contact with the inner circumferential surface of the first hole 41, and the portion, which is in contact with the inner circumferential surface of the first hole 41, may be soldered to the land formed on the substrate 24. Further, in the case where the groove portion 43 is formed in the inner circumferential surface of the first hole 41 in the direction in which the lead 23 is inserted, the bent portion 60 may be soldered to the land formed on the substrate 24 in a state where the bent portion 60 is inserted through the groove portion 43.

### 2. Second Embodiment

The electronic component 1 according to the first embodiment has been described, in which the lead 23 has the bent portion 60, and the lead 23 is configured in an L shape in a side view, as illustrated in Fig. 2. An electronic component 1 according to a second embodiment differs from the electronic component 1 of the first embodiment in that the lead 23 has a plurality of bent portions 60. Hereinafter, the second embodiment will be described based on the difference from the first embodiment.

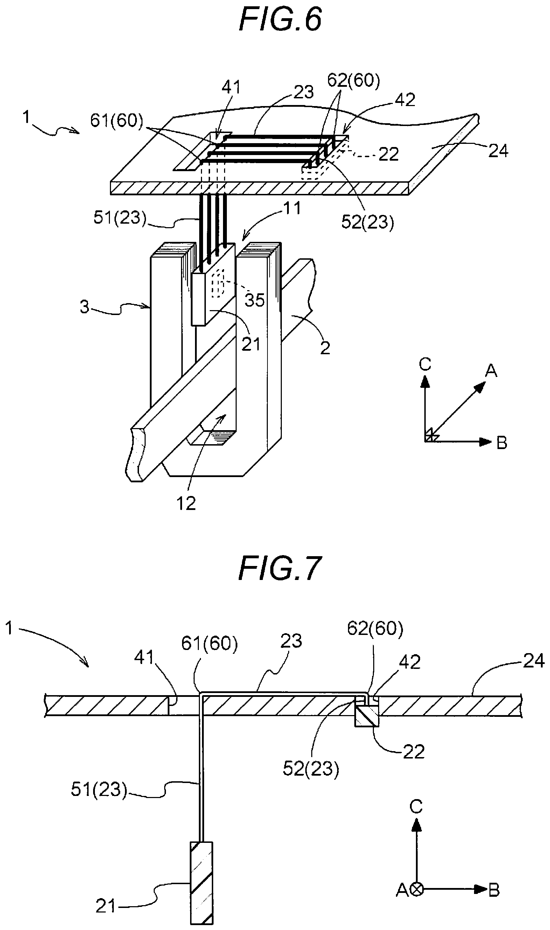

Fig. 6 illustrates a perspective view of the electronic component 1 according to the present embodiment. In addition, Fig. 7 illustrates a side sectional view of the electronic component 1 of the present embodiment. As illustrated in Fig. 6, even in the present embodiment, the electronic component 1 has a first package 21, a second package 22, and leads 23. An element 35 is sealed in the first package 21, and the first package 21 and a first package side portion 51 are inserted through a first hole 41 of a substrate 24.

Here, in a case where the bent portion 60 is regarded as a first bent portion 61, the lead 23 has a second bent portion 62 bent between the first bent portion 61 and the second package 22, in the present embodiment. The second bent portion 62 is bent in the same direction as the first bent portion 61 (in the direction C in the example of Fig. 6) with respect to the direction in which the lead 23 extends. Therefore, the lead 23 is formed in an L shape as illustrated in Fig. 7 when viewed from the lateral side of the electronic component 1.

In the present embodiment, the second package 22 and a second package side portion 52 of the lead 23 closer to the second package 22 than the second bent portion 62 are inserted through a second hole 42. Therefore, the second package 22 is disposed at least so as not to protrude from the surface of the substrate 24 (surface at a side where the second package 22 is inserted). In this case, similar to the first embodiment, the second hole 42 may have a size equal to a size of the second package 22 so that the second package 22 is fixed by being press-fitted into the second hole 42. Of course, similar to the first package 21, the second package 22 may be provided to protrude from a back surface of the substrate 24, and the second package 22 may not be fixed by being press-fitted into the second hole 42.

### 3. Other Embodiments

In the first and second embodiments, the element 35 has been described as a Hall element, but the element 35 may be an element having other functions. Therefore, the electronic component 1 may be a component having a function different from the function of the Hall IC.

In the first and second embodiments, the second package 22 has been described as being fixed by being press-fitted into the second hole 42, but the second package 22 may not be fixed by being press-fitted into the second hole 42, and the size of the second hole 42 may be sufficiently larger than the size of the second package 22.

In the first and second embodiments, the first package side portion 51 has been described as being in contact with the inner circumferential surface of the first hole 41, but the first package side portion 51 may be provided to be spaced apart from the inner circumferential surface of the first hole 41.

In the first and second embodiments, the configuration in which the first hole 41 has the groove portion 43 formed in the inner circumferential surface of the first hole 41 and the first package side portion 51 is inserted through the groove portion 43 has been described, but the first hole 41 may not have the groove portion 43.

In the first and second embodiments, the configuration in which the plurality of leads 23 is provided in parallel to one another, both the outer leads 23 of the leads 23 in the parallel direction of the plurality of leads 23 are disposed such that only the outer portions of the lands 25 in the parallel direction in a top plan view protrude from the outer leads 23 has been described, but the plurality of leads 23 may not be parallel to one another, and among the plurality of leads 23, both the outer leads 23 in the parallel direction of the leads 23 may be configured such that the outer portions of the lands 25 in the parallel direction in a top plan view do not protrude from the outer leads 23.

In the first and second embodiments, the configuration in which the plurality of leads 23 are configured as the four leads 23 including the unused lead which is not used has been described, but the plurality of leads 23 may be configured as five leads 23 or three or less leads 23. In addition, the plurality of leads 23 may not include the unused lead. In this case, the plurality of leads may not be connected by soldering.

The disclosure may be used for an electronic component mounted on a substrate.

## Claims

1. An electronic component (1) comprising:
a first package (21) having an element (35) sealed therein;
a lead (23) electrically connected to the element (35) in the first package (21) and including a bent portion (60), that is bent outside the first package (21), and a first package side portion (51), that is closer to the first package (21) than the bent portion (60) in the lead (23) ;
a second package (22) provided at an end opposite to an end to which the first package (21) is connected among both ends of the lead (23); and
a substrate (24) including a first hole (41) adapted to allow the insertion of the first package (21) and the first package side portion (51) therethrough , and a second hole (42) into which at least a part of the second package (22) is inserted.

2. The electronic component according to claim 1,
wherein when the bent portion is regarded as a first bent portion (61), the lead (23) has a second bent portion (62) bent between the first bent portion (61) and the second package (22), and
the second package (22) and a second package side portion (52) of the lead (23), that is closer to the second package (22) than the second bent portion (61) in the lead (23), are inserted into the second hole (42).

3. The electronic component according to claim 1 or 2,
wherein the second package (22) is press-fitted into the second hole (42).

4. The electronic component according to any one of claims 1 to 3,
wherein the first package side portion (51) of the lead (23) is in contact with an inner circumferential surface of the first hole (41).

5. The electronic component according to claim 4,
wherein the first hole (41) has a groove portion (43) formed in the inner circumferential surface of the first hole (41) in an insertion direction of the lead (23), and the first package side portion (51) is inserted through the groove portion (43).

## Patentansprüche

1. Elektronische Komponente (1), umfassend:
ein erstes Gehäuse (21), das ein darin versiegeltes Element (35) aufweist,
eine Leitung (23), die elektrisch mit dem Element (35) in dem ersten Gehäuse (21) verbunden ist und eine gekrümmte Sektion (60), die außerhalb des ersten Gehäuses (21) gekrümmt ist, und eine erste Gehäuseseitensektion (51) beinhaltet, die sich näher an dem ersten Gehäuse (21) befindet als die gekrümmte Sektion (60) in der Leitung (23),
ein zweites Gehäuse (22), das an einem Ende von beiden Enden der Leitung (23) vorgesehen ist, das einem Ende entgegengesetzt ist, mit dem das erste Gehäuse (21) verbunden ist, und
ein Substrat (24), das eine erste Öffnung (41), die dazu geeignet ist, das Einsetzen des ersten Gehäuses (21) und der ersten Gehäuseseitensektion (51) durch sie zu ermöglichen, und eine zweite Öffnung (42) beinhaltet, in die zumindest ein Teil des zweiten Gehäuses (22) eingesetzt ist.

2. Elektronische Komponente nach Anspruch 1,
wobei, wenn die gekrümmte Sektion als eine erste gekrümmte Sektion (61) betrachtet wird, die Leitung (23) eine zweite gekrümmte Sektion (62) aufweist, die zwischen der ersten gekrümmten Sektion (61) und dem zweiten Gehäuse (22) gekrümmt ist, und
das zweite Gehäuse (22) und eine zweite Gehäuseseitensektion (52) der Leitung (23), die sich näher an dem zweiten Gehäuse (22) befindet als die zweite gekrümmte Sektion (61) in der Leitung (23), in die zweite Öffnung (42) eingesetzt sind.

3. Elektronische Komponente nach Anspruch 1 oder 2,
wobei das zweite Gehäuse (22) in die zweite Öffnung (42) pressgepasst ist.

4. Elektronische Komponente nach einem der Ansprüche 1 bis 3,
wobei die erste Gehäuseseitensektion (51) der Leitung (23) mit einer inneren Umfangsoberfläche der ersten Öffnung (41) in Kontakt ist.

5. Elektronische Komponente nach Anspruch 4,
wobei die erste Öffnung (41) eine Rillensektion (43) aufweist, die in der inneren Umfangsoberfläche der ersten Öffnung (41) in einer Einsetzungsrichtung der Leitung (23) gebildet ist, und die erste Gehäuseseitensektion (51) durch die Rillensektion (43) eingesetzt ist.

## Revendications

1. Composant électronique (1) comprenant :
un premier boîtier (21) ayant un élément (35) scellé dedans ;
un fil (23) électriquement relié à l'élément (35) dans le premier boîtier (21) et incluant une partie pliée (60), qui est pliée à l'extérieur du premier boîtier (21), et une partie du côté premier boîtier (51), qui est plus près du premier boîtier (21) que la partie pliée (60) dans le fil (23) ;
un deuxième boîtier (22) prévu à une extrémité opposée à une extrémité à laquelle le premier boîtier (21) est relié parmi les deux extrémités du fil (23) ; et
un substrat (24) comprenant un premier trou (41) prévu pour permettre l'insertion du premier boîtier (21) et de la partie du côté premier boîtier (51) à travers, et un deuxième trou (42) dans lequel au moins une partie du deuxième boîtier (22) est insérée.

2. Composant électronique selon la revendication 1,
dans lequel, quand la partie pliée est considérée comme une première partie pliée (61), le fil (23) a une deuxième partie pliée (62) pliée entre la première partie pliée (61) et le deuxième boîtier (22), et
le deuxième boîtier (22) et une partie du côté deuxième boîtier (52) du fil (23), qui est plus près du deuxième boîtier (22) que la deuxième partie pliée (61) dans le fil (23), sont insérés dans le deuxième trou (42).

3. Composant électronique selon la revendication 1 ou 2,
dans lequel le deuxième boîtier (22) est emmanché dans le deuxième trou (42).

4. Composant électronique selon l'une quelconque des revendications 1 à 3,
dans lequel la partie du côté premier boîtier (51) du fil (23) est en contact avec une surface circonférentielle intérieure du premier trou (41).

5. Composant électronique selon la revendication 4,
dans lequel le premier trou (41) a une partie de rainure (43) formée dans la surface circonférentielle intérieure du premier trou (41) dans une direction d'insertion du fil (23), et la partie du côté premier boîtier (51) est insérée à travers la partie de rainure (43) .
